# FASCICULE DE BREVET EUROPEEN

(11) **EP 3 195 709 B1**
(45) Date de publication et mention de la délivrance du brevet: **02.12.2020**
(21) Numéro de dépôt: 15759875.6
(22) Date de dépôt: 30.07.2015
(51) Int. Cl.: H05K 5/02

(54) **BOITIER COMPORTANT UNE PAROI MUNIE D'UNE ENCEINTE DE PROTECTION D'UNE VALVE, ET SYSTEME COMPORTANT UN TEL BOITIER**
GEHÄUSE MIT EINER WAND MIT EINEM SCHUTZGEHÄUSE EINES VENTILS UND SYSTEM MIT SOLCH EINEM GEHÄUSE
HOUSING INCLUDING A WALL PROVIDED WITH A PROTECTIVE ENCLOSURE OF A VALVE, AND SYSTEM INCLUDING SUCH A HOUSING

(30) Priorité: 09.09.2014 FR 1458446
(43) Date de publication de la demande: 26.07.2017
(73) Titulaire: Valeo Systèmes de Contrôle Moteur, 95892 Cergy - Pontoise (FR)
(72) Inventeur: FEUILLAS, Sébastien, F-95740 Frepillon (FR); GOVINDASSAMY, Valery, F-95800 Cergy (FR)
(74) Mandataire: Cardon, Nicolas
(86) Numéro de dépôt international: PCT/FR2015/052110
(87) Numéro de publication internationale: WO 2016/038259

(56) Documents cités:
- EP-A1- 1 784 066
- DE-A1-102012 223 332
- JP-A- 2007 048 585
- US-A1- 2006 054 019

## Description

### DOMAINE TECHNIQUE

La présente invention concerne un boîtier muni d'une enceinte de protection d'une valve.

Dans la description et les revendications qui vont suivre, les éléments seront situés entre eux en référence à une direction arbitraire bas/haut, destinée par exemple à correspondre à la direction verticale sur la Terre.

### ARRIÈRE-PLAN TECHNOLOGIQUE

En cas de variation de température, la pression interne d'un boîtier peut augmenter ou baisser. Pour éviter ces variations de pression interne, qui vont générer des contraintes mécaniques dans les joints d'étanchéité et provoquer leur défaillance, il est connu d'utiliser une valve d'équilibrage de pression.

Certaines valves connues sont destinées à être clippées dans une ouverture ménagée dans une paroi du boîtier. Il est alors généralement prévu un joint torique en silicone ou en EPDM destiné à être compressé entre le corps de la capsule et la paroi du boîtier pour assurer l'étanchéité.

Par ailleurs, il est connu de munir la paroi du boîtier d'un muret entourant la capsule afin de se prémunir du risque de déclippage lié à une mauvaise manipulation, par exemple humaine. La hauteur du muret est toujours supérieure ou égale à celle de la valve clippée.

Afin de pouvoir disposer la valve sur une paroi horizontale, il est connu de fractionner le muret (par exemple par des espacements d'environ 5 mm), ce qui permet d'éviter la rétention d'eau par le muret tout en minimisant le risque de déclippage accidentel.

Le document JP 2007 048585 A décrit un boitier muni d'un tel muret.

Cependant, dans ce dernier cas, il a été remarqué qu'au bout d'un certain temps, l'étanchéité se dégradait.

Par ailleurs, le document DE 10 2012 223332 A1 décrit un boitier selon le préambule de la revendication 1.

L'invention a pour but de proposer un boîtier présentant une paroi présentant une ouverture de réception d'une valve, et permettant à la fois de réduire les risques de mauvaise manipulation de la valve et d'obtenir une bonne étanchéité dans le temps.

### RÉSUMÉ DE L'INVENTION

À cet effet, il est proposé un boîtier selon la revendication 1 ou 3.

En effet, il a été remarqué qu'au cours du temps un clippage de la valve d'équilibrage de pression subit parfois un vieillissement thermique qui provoque un relâchement de l'effort exercé sur un joint d'étanchéité compressé entre le corps de la capsule et la paroi du boîtier. Ceci peut être remarqué lors d'essais de validation climatique standard des normes automobiles. En fonctionnement normal, ce relâchement n'a pas d'incidence, mais en cas de lavage au moyen d'un jet d'eau à haute pression, ce jet d'eau peut alors provoquer un léger basculement de la valve provoquant une entrée d'eau dans le boîtier par un interstice entre le joint d'étanchéité et la paroi du boîtier.

Grâce à l'invention, les parties basses de l'enceinte permettent d'éviter au moins en partie qu'un jet d'eau à haute pression puisse atteindre l'interstice entre le joint d'étanchéité et la paroi du boîtier, tandis que les parties hautes de l'enceinte permettent de diminuer le risque de déclippage lié à une mauvaise manipulation de la valve. La différence de hauteur entre les parties hautes et basses de l'enceinte permet de se prémunir du risque de rétention d'eau dans l'enceinte qui ne permettrait plus à la valve d'assurer sa fonction principale d'équilibrage de pression.

Selon l'invention, une partie principale de la face supérieure s'étend autour de l'enceinte.

Selon l'invention également, la partie principale de la face supérieure s'étend au même niveau que le bord de l'ouverture le long de la direction bas-haut ou la partie principale de la face supérieure s'étend à un niveau plus élevé que le bord de l'ouverture le long de la direction bas-haut.

De façon optionnelle, les parties basses de l'enceinte sont respectivement formées par des marches connectant la partie principale de la face supérieure au bord de l'ouverture, et l'enceinte comporte des murets s'élevant, d'un côté, du bord de l'ouverture et, de l'autre côté, de la partie principale de la face supérieure, les murets formant respectivement les parties hautes de l'enceinte ou bien l'enceinte comporte un muret s'élevant, d'un côté, du bord de l'ouverture et, de l'autre côté, de la face supérieure, notamment de la partie principale de la face supérieure, le muret formant les parties hautes et basses de l'enceinte.

De façon optionnelle également, les parties hautes de l'enceinte présentent une hauteur par rapport au bord de l'ouverture comprise entre 1 mm et 10 mm.

De manière générale, la hauteur des parties hautes est choisie en fonction de la valve destinée à être insérée dans l'ouverture pour toujours être au même niveau ou à un niveau plus élevé le long de la direction bas-haut que cette valve.

De façon optionnelle également, les parties basses de l'enceinte présentent une hauteur par rapport au bord de l'ouverture comprise entre 1 mm et 4 mm.

De façon optionnelle également, les parties hautes de l'enceinte présentent une hauteur par rapport au bord de l'ouverture plus grande d'au moins 4 mm par rapport à une hauteur présentée par les parties basses de l'enceinte par rapport au bord de l'ouverture.

Il est également proposé un système comportant : un boîtier selon l'invention ; une valve d'équilibrage de pression entre l'espace intérieur du boîtier et l'espace extérieur du boîtier, la valve comportant : un corps situé au-dessus de l'ouverture, le corps étant muni d'une ouverture de passage d'air communiquant avec l'espace extérieur du boîtier ; une base, notamment insérée dans l'ouverture, et fixée à la paroi du boîtier pour maintenir la valve en place ; dans lequel les parties hautes de l'enceinte sont à un niveau plus élevé que le corps de la valve le long de la direction bas-haut, et dans lequel les parties basses de l'enceinte sont à un niveau moins élevé que l'ouverture de passage d'air le long de la direction bas-haut.

Par exemple, le système est un système électronique dans lequel des composants électroniques sont logés dans le boîtier. Par exemple, le système est un convertisseur de tension.

De façon optionnelle, le corps est verticalement séparé du bord de l'ouverture par un interstice vertical, et dans lequel les parties basses de l'enceinte sont à un niveau plus élevé que l'interstice le long de la direction bas-haut.

De façon optionnelle également, la paroi présente autour de l'ouverture une épaisseur biseautée, et le système comporte en outre un joint d'étanchéité entre l'épaisseur biseautée et le corps de la valve.

### DESCRIPTION DES FIGURES

Des modes de réalisation de l'invention vont à présent être décrits à titre d'exemple uniquement, en référence aux figures suivantes.
La figure 1 est une vue en trois dimensions d'un premier système selon l'invention.
La figure 2 est une vue en coupe transversale du premier système de la figure 1.
Les figures 3 et 4 sont des vues similaires aux figures 1 et 2 pour un second système selon l'invention.

### DESCRIPTION DÉTAILLÉE

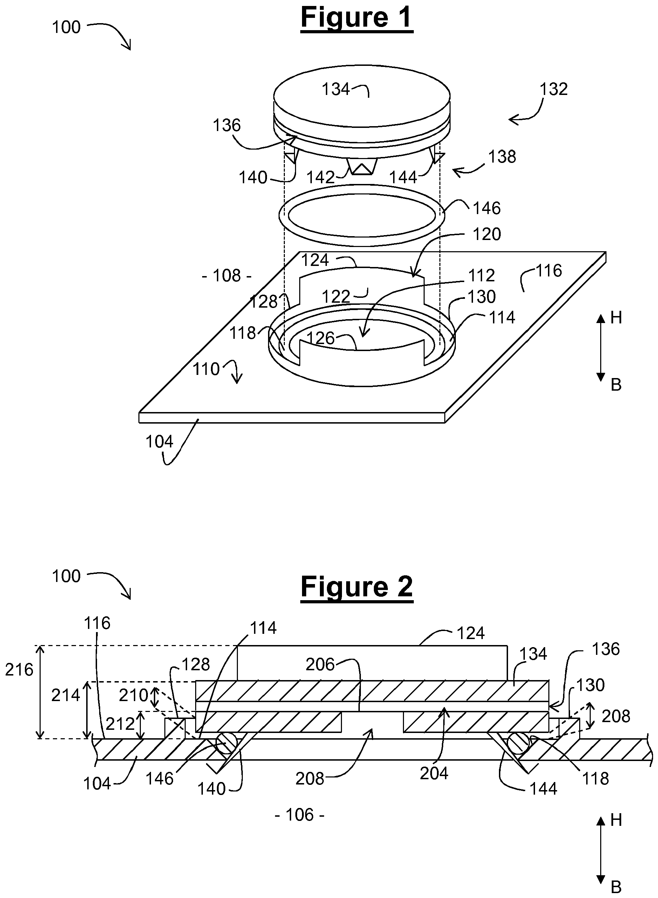

En référence aux figures 1 et 2, un premier système 100 selon l'invention va à présent être décrit.

En référence à la figure 1, le premier système 100 comporte tout d'abord un boîtier dont une paroi 104 est représentée. Le boîtier est destiné à contenir des équipements électroniques (non représentés) par exemple pour un véhicule automobile. De préférence, le boîtier est hermétique à la poussière et à l'eau. Par exemple, le boîtier répond à la norme IP66/IPX8/IPX9K (ISO 20653).

La paroi 104 est horizontale et délimite, en dessous, un espace intérieure 106 du boîtier et, au-dessus, un espace extérieur 108 du boitier.

La paroi 104 présente une face supérieure 110 orientée vers le haut, c'est-à-dire vers l'espace extérieur 108.

Une ouverture 112 est ménagée dans la paroi 104. L'ouverture 112 fait communiquer l'espace intérieur 106 du boîtier avec l'espace extérieur 108 du boîtier. Dans l'exemple décrit, l'ouverture 106 est circulaire et s'étend horizontalement.

Une partie de la face supérieure 110 de la paroi 104 entoure l'ouverture 112 et constitue un bord 114 de cette ouverture 112. Une autre partie de la face supérieure 110, appelée partie principale 116, s'étend autour du bord 114 de l'ouverture 112. Dans l'exemple décrit, la partie principale 116 de la face supérieure 110 de la paroi 104 s'étend à la même hauteur que le bord 114 de l'ouverture 112. Par ailleurs, le bord 114 de l'ouverture 112 présente une épaisseur biseautée 118.

Le boîtier comporte en outre une enceinte crénelée 120 s'élevant depuis le bord 114 de l'ouverture 112 et destinée à protéger une valve introduite dans l'ouverture 112 comme cela sera décrit plus loin. L'enceinte crénelée 120 entoure le bord 114 de l'ouverture 112 et sépare la partie principale 116 de la face supérieure 110 de la paroi 104, du bord 114 de l'ouverture 112. L'enceinte crénelée 120 comporte au moins deux parties hautes 124, 126 alternant avec au moins deux parties basses 128, 130. Les parties hautes 124, 126 sont plus hautes ques les parties basses 128, 130 depuis le bord 114 de l'ouverture 112, par exemple de 5 mm ou plus.

Dans l'exemple décrit, l'enceinte crénelée 120 comporte un muret crénelé 122 s'élevant, d'un côté, depuis le bord 114 de l'ouverture 112 et, de l'autre côté, depuis la partie principale 116 de la face supérieure 110 de la paroi 104. Le muret 122 forme les parties hautes 124, 126 et les parties basses 128, 130. Sur la figure 1, pour raison de clarté de la figure, le muret 122 est représenté sans épaisseur. Cependant, le muret 122 présente de préférence une épaisseur comprise entre 1 mm et 10 mm.

Le premier système 100 comporte en outre une valve d'équilibrage de pression 132 destinée à être placée dans l'ouverture 112 de manière à équilibrer la pression entre l'espace intérieur 106 du boîtier et l'espace extérieur 108 du boîtier .

La valve d'équilibrage de pression 132 comporte tout d'abord un corps 134 destiné à être situé au-dessus de l'ouverture 112 lorsque la valve d'équilibrage de pression 132 est en place dans l'ouverture 112. Le corps 134 est muni d'une ouverture de passage d'air 136 débouchant dans l'espace extérieur 108 du boîtier. Dans l'exemple décrit, le corps 134 présente la forme générale d'un palet circulaire autour de la direction bas/haut B-H. Le palet circulaire présente ainsi un chant circonférentiel. Dans l'exemple décrit, l'ouverture de passage d'air 136 s'étend circonférentiellement dans le chant du corps 134.

La valve d'équilibrage de pression 132 comporte en outre une base 138 s'étendant depuis le corps 134 vers le bas et destinée à être insérée dans l'ouverture 112 pour être fixée à la paroi 104 du boîtier, de manière à maintenir en place la valve d'équilibrage de pression 132. Dans l'exemple décrit, la base 138 comporte des jambes 140, 142, 144 destinées à être clippées dans l'ouverture 112.

Le premier système 100 comporte en outre un joint d'étanchéité 146 destiné à être intercalé entre l'épaisseur biseauté 118 du bord 114 de l'ouverture 112 et le corps 134 de la valve d'équilibrage de pression 132. Dans l'exemple décrit, il s'agit d'un joint torique.

En référence à la figure 2, la valve d'équilibrage de pression 132 comporte, dans l'exemple décrit, une ouverture inférieure 202 débouchant sur l'espace intérieur 106 du boîtier, et un conduit 204 reliant l'ouverture de passage d'air 136 à l'ouverture inférieure 202. La valve d'équilibrage de pression 132 comporte en outre une membrane 206 obstruant le conduit 204. Ainsi, la communication d'air entre l'espace extérieur 108 du boîtier et l'espace intérieur 106 du boîtier se fait au travers du conduit 204 et donc de la membrane 206. La membrane 206 est de préférence poreuse, par exemple en PTFE (polytétrafluoroéthylène). La taille des pores de la membrane 206 et leur densité permet d'assurer un flux d'air minimum afin de remettre rapidement (moins de 10 secondes) à pression atmosphérique la pression intérieur du boîtier en cas de variation de température. La porosité de la membrane 206 est dimensionnée afin de ne pas permettre le passage de molécules d'eau sous forme liquide, de sorte que le niveau d'étanchéité du boîtier ne soit pas dégradé.

Par ailleurs, le corps 134 de la valve d'équilibrage de pression 132 est verticalement séparé du bord 114 de l'ouverture 112 par un interstice vertical 208. Afin d'empêcher qu'un jet d'eau atteigne cet interstice vertical 208, les parties basses 128, 130 de l'enceinte 120 présentent une hauteur 210 supérieure à cet interstice vertical 208.

Par ailleurs, l'ouverture de passage d'air 136 de la valve d'équilibrage de pression 132 est situé verticalement à une hauteur 212 du bord 114 de l'ouverture 112. Afin d'empêcher que l'eau retenue par l'enceinte 120 n'entre dans l'ouverture de passage d'air 136, la hauteur 210 des parties basses 128, 130 de l'enceinte 120 est inférieure à cette hauteur 212.

Par ailleurs, le corps 134 de la valve d'équilibrage de pression 132 s'élève verticalement à une hauteur 214 au dessus du bord 114 de l'ouverture 112. Pour éviter que la valve d'équilibrage de pression 132 ne soit retirée par erreur, les parties hautes 124, 126 de l'enceinte 120 présentent une hauteur 216 supérieure à la hauteur 214 du corps 134.

De préférence, les parties hautes 124, 126 de l'enceinte 120 présentent une hauteur 210 par rapport au bord 114 de l'ouverture 112 comprise entre 1 mm et 10 mm.

De préférence également, les parties basses 128, 130 de l'enceinte 120 présentent une hauteur par rapport au bord de l'ouverture comprise entre 1 mm et 4 mm.

De préférence également, les parties hautes de l'enceinte présentent une hauteur par rapport au bord de l'ouverture plus grande d'au moins 4 mm par rapport à une hauteur présentée par les parties basses de l'enceinte par rapport au bord 114 de l'ouverture 112.

De préférence également, l'enceinte 120 est horizontalement à une distance comprise entre 1 mm et 5 mm du corps 134 de la valve d'équilibrage de pression 132.

Cependant, les dimensions du boîtier sont fonction de celles de la capsule.

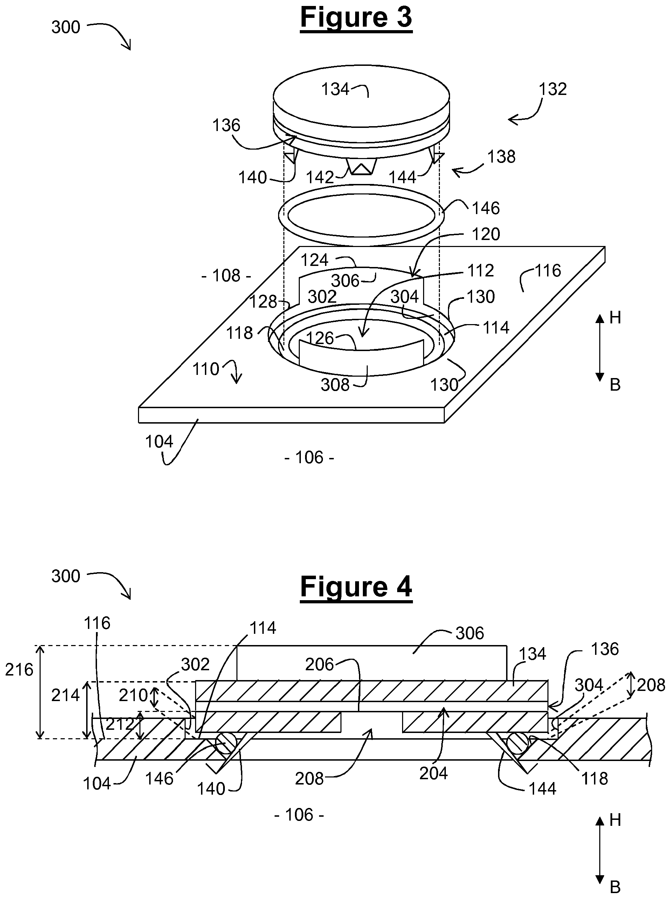

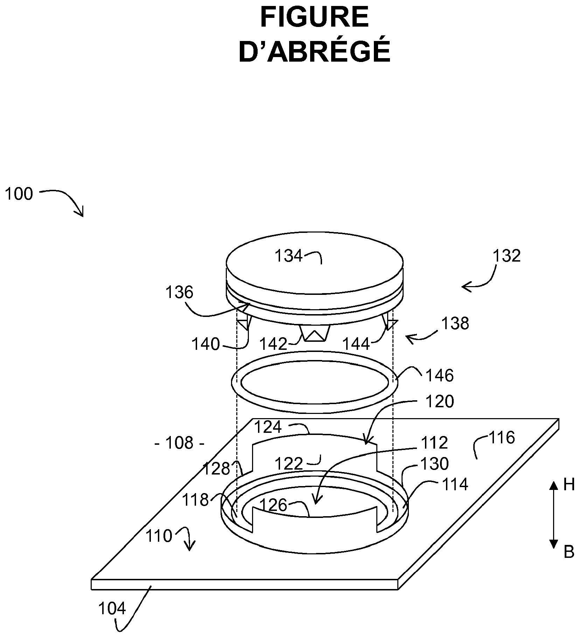

En référence aux figures 3 et 4, un second système 300 selon l'invention va à présent être décrit.

Les parties du second système 300 identiques à celles du premier système 100 seront désignées par les mêmes références et ne seront pas décrites à nouveau.

Dans le second système 300, la partie principale 116 de la face supérieure 110 de la paroi 104 s'étend plus haut que le bord 114 de l'ouverture 112. Les parties basses 128, 130 de l'enceinte 120 sont alors respectivement formées par des marches 302, 304 connectant la partie principale 116 de la face supérieure au bord 114 de l'ouverture 112.

Par ailleurs, l'enceinte 120 comporte au moins deux murets 306, 308 s'élevant, d'un côté, du bord 114 de l'ouverture 112 et, de l'autre côté, depuis la partie principale 116 de la face supérieure 110 de la paroi 104. Ces murets 306, 308 forment respectivement les parties hautes 126, 124 de l'enceinte 120. Sur la figure 3, pour raison de clarté de la figure, les murets 306, 308 sont représentés sans épaisseur. Cependant, les murets 306, 308 présentent de préférence une épaisseur comprise entre 1 mm et 10 mm.

La présente invention n'est pas limitée aux modes de réalisation décrits précédemment, mais est au contraire définie par les revendications qui suivent.

**LISTE DES REFERENCES**

| | |
|---|---|
| Premier système | 100 |
| Paroi | 104 |
| Espace intérieur | 106 |
| Espace extérieur | 108 |
| Face supérieure | 110 |
| Ouverture | 112 |
| Bord (de l'ouverture) | 114 |
| Partie principale (de la face supérieure) | 116 |
| Épaisseur biseautée (du bord) | 118 |
| Enceinte crénelée | 120 |
| Muret crénelé | 122 |
| Parties hautes | 124, 126 |
| Parties basses | 128, 130 |
| Valve d'équilibrage de pression | 132 |
| Corps | 134 |
| Ouverture de passage d'air | 136 |
| Base | 138 |
| Jambes | 140, 142, 144 |
| Joint d'étanchéité | 146 |
| Ouverture inférieure | 202 |
| Conduit | 204 |
| Membrane | 206 |
| Interstice vertical | 208 |
| Hauteur (des parties basses de l'enceinte) | 210 |
| Hauteur (entre le bord et l'ouverture de passage d'air) | 212 |
| Hauteur (entre le bord et le haut du corps) | 214 |
| Hauteur (des parties hautes de l'enceinte) | 216 |
| Second système | 300 |
| Marches (entre la partie principale de la face supérieure et le bord) | 302, 304 |
| Murets | 306, 308 |

## Revendications

1. Boîtier, notamment d'un système électronique, comportant :
- une paroi (104) présentant une face supérieure (106) orientée vers le haut suivant une direction bas/haut (B-H), et dans laquelle une ouverture (112) est ménagée, l'ouverture (112) étant destiné à recevoir une valve (132) d'équilibrage de pression, l'ouverture (112) étant entourée d'une partie de la face supérieure (106) constituant un bord (114) de l'ouverture (112), et faisant communiquer un espace intérieur (106) du boîtier, situé en-dessous de la paroi (104), avec un espace extérieur (108) du boîtier, situé au-dessus de la paroi (104),
- une enceinte (120) destinée à protéger la valve (132) reçue dans l'ouverture (112), l'enceinte étant crénelée et entourant le bord (114) de l'ouverture (112), l'enceinte (120) s'élevant depuis le bord (114) de l'ouverture (112), et l'enceinte (120) comportant au moins deux parties hautes (124, 126) alternant avec au moins deux parties basses (128, 130), l'enceinte (120) comportant un muret formant les parties hautes (124, 126) et basses (128, 130) de l'enceinte (120),
ledit boîtier étant **caractérisé en ce qu'**une partie principale (116) de la face supérieure (110) s'étend autour de l'enceinte (120) à un niveau plus élevé que le bord (114) de l'ouverture (112) le long de la direction bas-haut (B-H).

2. Boîtier selon la revendication 1, dans lequel les parties basses (128, 130) de l'enceinte (120) sont respectivement formées par des marches (302, 304) connectant la partie principale (116) de la face supérieure (110) au bord (114) de l'ouverture (112), et dans lequel l'enceinte (120) comporte des murets (306, 308) s'élevant, d'un côté, du bord (114) de l'ouverture (112) et, de l'autre côté, de la partie principale (116) de la face supérieure (110), les murets (306, 308) formant respectivement les parties hautes (124, 126) de l'enceinte (120).

3. Boîtier, notamment d'un système électronique, comportant :
- une paroi (104) présentant une face supérieure (106) orientée vers le haut suivant une direction bas/haut (B-H), et dans laquelle une ouverture (112) est ménagée, l'ouverture (112) étant destiné à recevoir une valve (132) d'équilibrage de pression, l'ouverture (112) étant entourée d'une partie de la face supérieure (106) constituant un bord (114) de l'ouverture (112), et faisant communiquer un espace intérieur (106) du boîtier, situé en-dessous de la paroi (104), avec un espace extérieur (108) du boîtier, situé au-dessus de la paroi (104),
- une enceinte (120) destinée à protéger la valve (132) reçue dans l'ouverture (112), l'enceinte étant crénelée et entourant le bord (114) de l'ouverture (112), l'enceinte (120) s'élevant depuis le bord (114) de l'ouverture (112), et l'enceinte (120) comportant au moins deux parties hautes (124, 126) alternant avec au moins deux parties basses (128, 130), l'enceinte (120) comportant un muret formant les parties hautes (124, 126) et basses (128, 130) de l'enceinte (120),
ledit boîtier étant **caractérisé en ce qu'**une partie principale (116) de la face supérieure (110) s'étend autour de l'enceinte (120) au même niveau que le bord (114) de l'ouverture (112) le long de la direction bas-haut (B-H) et **en ce que** les parties basses (128, 130) de l'enceinte (120) sont plus élevées que le bord (114) de l'ouverture (112)..

4. Boîtier selon l'une quelconque des revendications 1 à 3, dans lequel les parties hautes (124, 126) de l'enceinte (120) présentent une hauteur (216) par rapport au bord (114) de l'ouverture (112) comprise entre 1 mm et 10 mm.

5. Boîtier selon l'une quelconque des revendications 1 à 4, dans lequel les parties basses (128, 130) de l'enceinte (120) présentent une hauteur (210) par rapport au bord (114) de l'ouverture (112) comprise entre 1 mm et 4 mm.

6. Boîtier selon l'une quelconque des revendications 1 à 5, dans lequel les parties hautes (126, 126) de l'enceinte (120) présentent une hauteur (216) par rapport aux parties basses (128, 130) de l'enceinte (120) d'au moins 4 mm.

7. Système comportant :
- un boîtier selon l'une quelconque des revendications 1 à 6,
- une valve (132) d'équilibrage de pression entre l'espace intérieur (106) du boîtier et l'espace extérieur (108) du boîtier, la valve (132) comportant :
- un corps (134) situé au-dessus de l'ouverture (112), le corps (134) étant muni d'une ouverture de passage d'air (136) communiquant avec l'espace extérieur 108) du boîtier,
- une base (138) fixée à la paroi (104) du boîtier pour maintenir la valve (132) en place,
dans lequel les parties hautes (124, 126) de l'enceinte (120) sont à un niveau plus élevé que le corps (134) de la valve (132) le long de la direction bas-haut (B-H), et dans lequel les parties basses (128, 130) de l'enceinte (120) sont à un niveau moins élevé que l'ouverture de passage d'air (136) le long de la direction bas-haut (B-H).

8. Système selon la revendication 7, dans lequel le corps (134) est verticalement séparé du bord (114) de l'ouverture (112) par un interstice vertical (208), et dans lequel les partie basses (128, 130) de l'enceinte (120) sont à un niveau plus élevé que l'interstice (208) le long de la direction bas-haut (B-H).

9. Système selon la revendication 7 ou 8, dans lequel la paroi (104) présente autour de l'ouverture (112) une épaisseur biseautée (118), et comportant en outre un joint d'étanchéité (146) entre l'épaisseur biseautée (118) et le corps (134) de la valve (132).

## Patentansprüche

1. Gehäuse, insbesondere eines elektronischen Systems, aufweisend:
- eine Wand (104), die eine Oberseite (106) aufweist, die entlang einer Unten/Oben- (B-H-) Richtung nach oben gerichtet ist, und in welcher eine Öffnung (112) ausgebildet ist, wobei die Öffnung (112) dazu bestimmt ist, ein Druckausgleichsventil (132) aufzunehmen, wobei die Öffnung (112) von einem Abschnitt der Oberseite (106) umgeben ist, der einen Rand (114) der Öffnung (112) bildet, und einen Innenraum (106) des Gehäuses, der sich unter der Wand (104) befindet, mit einem Außenraum (108) des Gehäuses, der sich über der Wand (104) befindet, verbindet,
- eine Einhausung (120), die dazu bestimmt ist, das Ventil (132), das in der Öffnung (112) aufgenommen ist, zu schützen, wobei die Einhausung Zinnen aufweist und den Rand (114) der Öffnung (112) umgibt, wobei sich die Einhausung (120) von dem Rand (114) der Öffnung (112) erhebt und die Einhausung (120) mindestens zwei hohe Abschnitte (124, 126), die sich mit mindestens zwei tiefen Abschnitten (128, 130) abwechseln, aufweist, die Einhausung (120) aufweisend eine Wandung, die die hohen (124, 126) und tiefen Abschnitte (128, 130) der Einhausung (120) bildet,
wobei das Gehäuse **dadurch gekennzeichnet ist, dass** sich ein Hauptabschnitt (116) der Oberseite (110) auf einer höheren Ebene als der Rand (114) der Öffnung (112) entlang der Unten-Oben- (B-H-) Richtung um die Einhausung (120) erstreckt.

2. Gehäuse nach Anspruch 1, wobei die tiefen Abschnitte (128, 130) der Einhausung (120) jeweils von Stufen (302, 304) gebildet sind, die den Hauptabschnitt (116) der Oberseite (110) mit dem Rand (114) der Öffnung (112) verbinden, und wobei die Einhausung (120) Wandungen (306, 308) aufweist, die sich auf einer Seite vom Rand (114) der Öffnung (112) und auf der anderen Seite vom Hauptabschnitt (116) der Oberseite (110) erheben, wobei die Wandungen (306, 308) jeweils die hohen Abschnitte (124, 126) der Einhausung (120) bilden.

3. Gehäuse, insbesondere eines elektronischen Systems, aufweisend:
- eine Wand (104), die eine Oberseite (106) aufweist, die entlang einer Unten/Oben- (B-H-) Richtung nach oben gerichtet ist, und in welcher eine Öffnung (112) ausgebildet ist, wobei die Öffnung (112) dazu bestimmt ist, ein Druckausgleichsventil (132) aufzunehmen, wobei die Öffnung (112) von einem Abschnitt der Oberseite (106) umgeben ist, der einen Rand (114) der Öffnung (112) bildet, und einen Innenraum (106) des Gehäuses, der sich unter der Wand (104) befindet, mit einem Außenraum (108) des Gehäuses, der sich über der Wand (104) befindet, verbindet,
- eine Einhausung (120), die dazu bestimmt ist, das Ventil (132), das in der Öffnung (112) aufgenommen ist, zu schützen, wobei die Einhausung Zinnen aufweist und den Rand (114) der Öffnung (112) umgibt, wobei sich die Einhausung (120) von dem Rand (114) der Öffnung (112) erhebt und die Einhausung (120) mindestens zwei hohe Abschnitte (124, 126), die sich mit mindestens zwei tiefen Abschnitten (128, 130) abwechseln, aufweist, die Einhausung (120) aufweisend eine Wandung, die die hohen (124, 126) und tiefen Abschnitte (128, 130) der Einhausung (120) bildet,
wobei das Gehäuse **dadurch gekennzeichnet ist, dass** sich ein Hauptabschnitt (116) der Oberseite (110) auf derselben Ebene wie der Rand (114) der Öffnung (112) entlang der Unten-Oben- (B-H-) Richtung um die Einhausung (120) erstreckt, und dadurch, dass die tiefen Abschnitte (128, 130) der Einhausung (120) höher als der Rand (114) der Öffnung (112) sind.

4. Gehäuse nach einem der Ansprüche 1 bis 3, wobei die hohen Abschnitte (124, 126) der Einhausung (120) eine Höhe (216) bezogen auf den Rand (114) der Öffnung (112) aufweisen, die zwischen 1 mm und 10 mm beträgt.

5. Gehäuse nach einem der Ansprüche 1 bis 4, wobei die tiefen Abschnitte (128, 130) der Einhausung (120) eine Höhe (210) bezogen auf den Rand (114) der Öffnung (112) aufweisen, die zwischen 1 mm und 4 mm beträgt.

6. Gehäuse nach einem der Ansprüche 1 bis 5, wobei die hohen Abschnitte (126, 126) der Einhausung (120) eine Höhe (216) bezogen auf die tiefen Abschnitte (128, 130) der Einhausung (120) aufweisen, die mindestens 4 mm beträgt.

7. System, aufweisend:
- ein Gehäuse nach einem der Ansprüche 1 bis 6,
- ein Ventil (132) zum Druckausgleich zwischen dem Innenraum (106) des Gehäuses und dem Außenraum (108) des Gehäuses, das Ventil (132) aufweisend:
- einen Körper (134), der sich über der Öffnung (112) befindet, wobei der Körper (134) mit einer Luftdurchtrittsöffnung (136) versehen ist, die mit dem Außenraum (108) des Gehäuses in Verbindung steht,
- eine Basis (138), die an der Wand (104) des Gehäuses befestigt ist, um das Ventil (132) an Ort und Stelle zu halten,
wobei sich die hohen Abschnitte (124, 126) der Einhausung (120) entlang der Unten-Oben- (B-H-) Richtung auf einer höheren Ebene als der Körper (134) des Ventils (132) befinden, und wobei sich die tiefen Abschnitte (128, 130) der Einhausung (120) entlang der Unten-Oben- (B-H-) Richtung auf einer niedrigeren Ebene als die Luftdurchtrittsöffnung (136) befinden.

8. System nach Anspruch 7, wobei der Körper (134) durch einen vertikalen Zwischenraum (208) vertikal vom Rand (114) der Öffnung (112) getrennt ist, und wobei sich die tiefen Abschnitte (128, 130) der Einhausung (120) entlang der Unten-Oben- (B-H-) Richtung auf einer höheren Ebene als der Zwischenraum (208) befinden.

9. System nach Anspruch 7 oder 8, wobei die Wand (104) um die Öffnung (112) eine abgeschrägte Dicke (118) aufweist, und ferner aufweisend eine Dichtung (146) zwischen der abgeschrägten Dicke (118) und dem Körper (134) des Ventils (132).

## Claims

1. Housing, in particular for an electronic system, comprising:
- a wall (104) having an upper face (106) oriented upwards along a down-up (B-H) direction, and in which there is created an opening (112), the opening (112) being intended to receive a pressure equalizing valve (132), the opening (112) being surrounded by part of the upper face (106) forming an edge (114) of the opening (112), and establishing a communication between an internal space (106) of the housing, located below the wall (104), and an external space (108) of the housing, located above the wall (104),
- an enclosure (120) intended to protect the valve (132) received in the opening (112), the enclosure being notched and surrounding the edge (114) of the opening (112), the enclosure (120) rising from the edge (114) of the opening (112), and the enclosure (120) comprising at least two upper parts (124, 126) alternating with at least two lower parts (128, 130), the enclosure (120) comprising a low wall forming the upper parts (124, 126) and lower parts (128, 130) of the enclosure (120),
said housing being **characterized in that** a main part (116) of the upper face (110) extends around the enclosure (120) at a higher level than the edge (114) of the opening (112) along the down-up (B-H) direction.

2. Housing according to Claim 1, wherein the lower parts (128, 130) of the enclosure (120) are respectively formed by steps (302, 304) connecting the main part (116) of the upper face (110) to the edge (114) of the opening (112), and in which the enclosure (120) comprises low walls (306, 308) rising, on one hand, from the edge (114) of the opening (112) and, on the other hand, from the main part (116) of the upper face (110), the low walls (306, 308) respectively forming the upper parts (124, 126) of the enclosure (120) .

3. Housing, in particular for an electronic system, comprising:
- a wall (104) having an upper face (106) oriented upwards along a down-up (B-H) direction, and in which there is created an opening (112), the opening (112) being intended to receive a pressure equalizing valve (132), the opening (112) being surrounded by part of the upper face (106) forming an edge (114) of the opening (112), and establishing a communication between an internal space (106) of the housing, located below the wall (104), and an external space (108) of the housing, located above the wall (104),
- an enclosure (120) intended to protect the valve (132) received in the opening (112), the enclosure being notched and surrounding the edge (114) of the opening (112), the enclosure (120) rising from the edge (114) of the opening (112), and the enclosure (120) comprising at least two upper parts (124, 126) alternating with at least two lower parts (128, 130), the enclosure (120) comprising a low wall forming the upper parts (124, 126) and lower parts (128, 130) of the enclosure (120),
said housing being **characterized in that** a main part (116) of the upper face (110) extends around the enclosure (120) at the same level as the edge (114) of the opening (112) along the down-up (B-H) direction, and **in that** the lower parts (128, 130) of the enclosure (120) are higher than the edge (114) of the opening (112).

4. Housing according to any one of Claims 1 to 3, wherein the upper parts (124, 126) of the enclosure (120) have a height (216), relative to the edge (114) of the opening (112), of between 1 mm and 10 mm.

5. Housing according to any one of Claims 1 to 4, wherein the lower parts (128, 130) of the enclosure (120) have a height (210), relative to the edge (114) of the opening (112), of between 1 mm and 4 mm.

6. Housing according to any one of Claims 1 to 5, wherein the upper parts (126, 126) of the enclosure (120) have a height (216), relative to the lower parts (128, 130) of the enclosure (120), of at least 4 mm.

7. System comprising:
- a housing according to any one of Claims 1 to 6,
- a valve (132) for equalizing pressure between the internal space (106) of the housing and the external space (108) of the housing, the valve (132) comprising:
- a body (134) located above the opening (112), the body (134) being provided with an air passage opening (136) communicating with the external space (108) of the housing,
- a base (138) attached to the wall (104) of the housing to hold the valve (132) in place,
wherein the upper parts (124, 126) of the enclosure (120) are at a higher level than the body (134) of the valve (132) along the down-up (B-H) direction, and wherein the lower parts (128, 130) of the enclosure (120) are at a lower level than the air passage opening (136) along the down-up (B-H) direction.

8. System according to Claim 7, wherein the body (134) is vertically separated from the edge (114) of the opening (112) by a vertical gap (208), and wherein the lower parts (128, 130) of the enclosure (120) are at a higher level than the gap (208) along the down-up (B-H) direction.

9. System according to Claim 7 or 8, wherein the wall (104) has, around the opening (112), a bevelled thickness (118), and further comprising a seal (146) between the bevelled thickness (118) and the body (134) of the valve (132).
